Europäisches Patentamt

European Patent Office

Office européen des brevets

(19)

(11) Numéro de publication : **0 337 875 B1**

(12)

# FASCICULE DE BREVET EUROPEEN

(45) Date de publication du fascicule du brevet :
09.12.92 Bulletin 92/50

(51) Int. Cl.⁵ : **G01R 1/067**

(21) Numéro de dépôt : 89400989.3

(22) Date de dépôt : **11.04.89**

(54) **Testeur à pointe de touche et fourreau de protection rétractable.**

(30) Priorité : **14.04.88 FR 8804953**

(43) Date de publication de la demande :
**18.10.89 Bulletin 89/42**

(45) Mention de la délivrance du brevet :
**09.12.92 Bulletin 92/50**

(84) Etats contractants désignés :
**DE ES IT**

(56) Documents cités :
**US-A- 4 041 380**
**US-A- 4 263 547**

(73) Titulaire : **SOCIETE ANONYME DES ETS CATU**
**10/18 Avenue Jean-Jaurès**
**F-92222 Bagneux (FR)**

(72) Inventeur : **Arberet, Sylvestre**
**26 Rue de la Fosse Bazin**
**F-92260 Fontenay Aux Roses (FR)**

(74) Mandataire : **CABINET BONNET-THIRION**
**95 Boulevard Beaumarchais**
**F-75003 Paris (FR)**

EP 0 337 875 B1

Jouve, 18, rue Saint-Denis, 75001 PARIS

## Description

La présente invention concerne d'une manière générale les testeurs comportant, portée par un corps en matière isolante, une pointe de touche propre à permettre l'établissement d'un contact, par exemple pour le contrôle de la présence, ou non, d'une tension.

Elle vise plus particulièrement ceux de ces testeurs dans lesquels, pour des raisons de sécurité, il est prévu, entourant la pointe de touche, un fourreau de protection qui, à l'encontre de moyens élastiques de rappel, est monté mobile entre une position déployée de repos, pour laquelle il s'étend au-delà de l'extrémité de la pointe de touche, et une position rétractée de service, pour laquelle il dégage au moins partiellement celle-ci.

Grâce à un tel fourreau de protection, la pointe de touche est normalement inaccessible au repos.

En pratique, pour satisfaire les normes en vigueur dans ce domaine, il est nécessaire que, au repos, cette pointe de touche demeure ainsi inaccessible même lorsqu'il est exercé, sur son fourreau de protection, une poussée d'un décanewton.

Il importe donc que, pour cette position de repos, ce fourreau de protection soit verrouillé.

Mais le problème est alors que, pour permettre le passage de ce fourreau de protection de sa position déployée de repos à sa position rétractée de service, il faut au préalable le déverrouiller.

Dans certaines réalisations connues à ce jour, ce déverrouillage est obtenu en faisant tourner autour de son axe le fourreau de protection.

Bien que, pour d'autres raisons, ces réalisations donnent satisfaction, elles nécessitent, pour leur mise en oeuvre, une manipulation relativement lourde et malaisée.

En effet, cette mise en oeuvre implique l'exécution, de manière synchrone, de deux mouvements distincts, l'un, de rotation, nécessaire pour le déverrouillage du fourreau de protection, l'autre, de translation, nécessaire pour son passage de sa position déployée de repos à sa position rétractée de service.

Cette difficulté de mise en oeuvre s'accroît si, pour le contrôle de tension à effectuer, et comme cela est relativement fréquemment le cas, deux testeurs sont à manipuler en même temps.

Il n'est pas rare, dans ces conditions, que, au détriment de la sécurité, les utilisateurs de testeurs de ce type cherchent à en court-circuiter le fourreau de protection, par exemple en le bloquant en permanence en position rétractée de service.

Dans d'autres réalisations également connues à ce jour, le déverrouillage du fourreau de protection est obtenu en exerçant une poussée sur un organe de déverrouillage qui, spécifiquement prévu à cet effet, est propre à en permettre, et seulement à en permettre, la libération.

La mise en oeuvre de ces réalisations nécessitant elle aussi l'exécution de manière synchrone de deux opérations, l'une de poussée, à exercer sur l'organe de déverrouillage, l'autre de traction, à exercer sur le fourreau de protection, des inconvénients du même type que ceux précédemment exposés se retrouvent.

En outre, avec ces réalisations, la pointe de touche n'étant dégagée que lors du contact à assurer, l'utilisateur ne la voit pas à l'avance, ce qui ne facilite pas l'exécution de ce contact et rend au contraire malaisée cette exécution.

La présente invention a d'une manière générale pour objet une disposition permettant d'éliminer ces inconvénients.

De manière plus précise, elle a pour objet un testeur comportant, portée par un corps en matière isolante, une pointe de touche propre à permettre l'établissement d'un contact, avec, entourant ladite pointe de touche, un fourreau de protection qui, à l'encontre de moyens élastiques de rappel, est monté mobile entre une position déployée de repos, pour laquelle il s'étend au-delà de l'extrémité de la pointe de touche, et une position rétractée de service, pour laquelle il dégage au moins partiellement celle-ci, et qui est verrouillable en position de repos sous le contrôle d'un organe de déverrouillage propre à en permettre la libération, ce testeur étant d'une manière générale caractérisé en ce que ledit organe de déverrouillage est également propre à permettre d'assurer le déplacement du fourreau de protection de sa position déployée de repos à sa position rétractée de service.

Ainsi une seule opération, qui combine en un seul mouvement un mouvement élémentaire, en pratique imperceptible au doigt, d'enfoncement de l'organe de déverrouillage, et un mouvement principal, exercé à l'aide de ce même organe de déverrouillage, d'entraînement du fourreau de protection.

Tout en satisfaisant aux normes en vigueur, le testeur suivant l'invention est donc de mise en oeuvre particulièrement aisée et commode.

Il présente en outre une forme avantageusement ergonomique, cette forme pouvant de surcroît être choisie de manière à favoriser le respect de l'entr'axe correspondant à l'écartement international des broches ou alvéoles des prises de courant usuelles.

Les caractéristiques et avantages de l'invention ressortiront d'ailleurs de la description qui va suivre, à titre d'exemple, en référence aux dessins schématiques annexés sur lesquels :

la figure 1 est une vue en perspective du testeur suivant l'invention ;

la figure 2 en est une vue en coupe longitudinale, suivant la ligne II-II de la figure 1, pour la position déployée de repos du fourreau de protection qu'il comporte ;

la figure 3 reprend, à échelle supérieure, le détail de la figure 2 repéré par un encart III sur cette figure 2 ;

la figure 4 est, à l'échelle de la figure 3, une vue partielle en coupe transversale du testeur suivant l'invention, suivant la ligne IV-IV de cette figure 3 ;

la figure 5 est, suivant la flèche V de la figure 3, et à l'échelle de cette figure 3, une vue partielle de dessous d'une partie du corps en matière isolante de ce testeur ;

la figure 6 est, à échelle différente, et avec un arrachement local, une vue partielle en perspective de son fourreau de protection et de l'organe de déverrouillage associé à celui-ci ;

les figures 7 et 8 sont des vues partielles en coupe, qui, analogues, chacune respectivement, à celles des figures 3 et 4, illustrent le déverrouillage du fourreau de protection ;

la figure 9 est une vue en coupe longitudinale analogue à celle de la figure 2, pour la position rétractée de service de ce fourreau de protection.

Ces figures illustrent, à titre d'exemple, l'application de l'invention à un testeur "sur fil", c'est-à-dire à un testeur disposé en bout d'un cordon ou autre conducteur électrique 10 propre à sa mise en oeuvre.

Mais, il va de soi que ce testeur peut tout aussi bien être fixé à demeure sur un quelconque appareillage, et, notamment, sur un quelconque bloc vérificateur de tension.

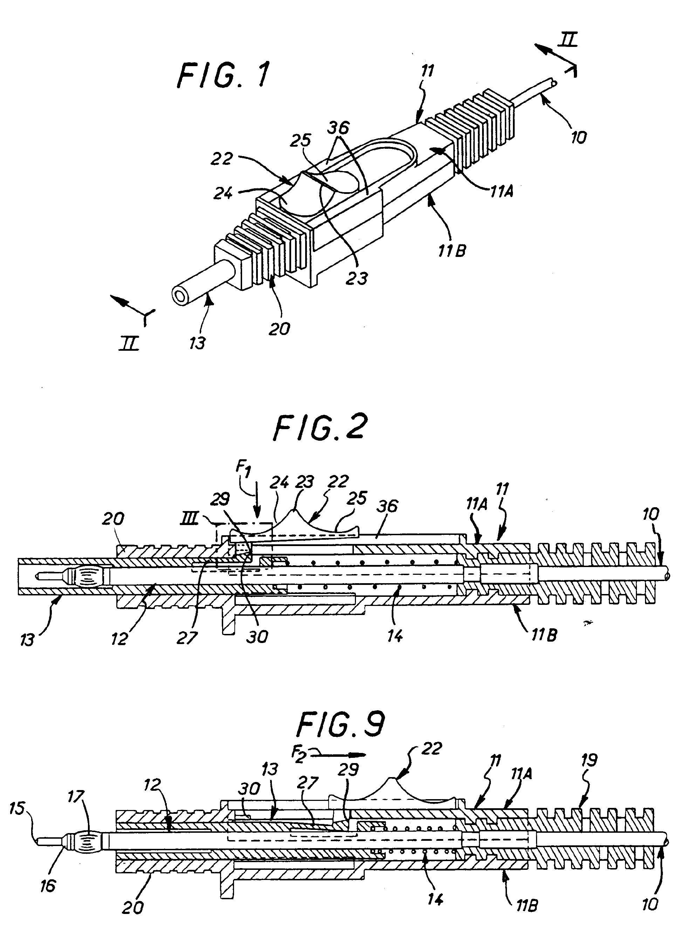

De manière connue en soi, le testeur suivant l'invention comporte, portée par un corps en matière isolante 11, une pointe de touche 12 propre à permettre l'établissement d'un contact, avec, entourant cette pointe de touche 12, un fourreau de protection 13 qui, à l'encontre de moyens élastiques de rappel, constitué, dans la forme de réalisation représentée, par un ressort du type ressort à boudin 14, est monté mobile entre une position déployée de repos, figure 2, pour laquelle il s'étend au-delà de l'extrémité de la pointe de touche 12, et une position rétractée de service, figure 9, pour laquelle il dégage au moins partiellement celle-ci.

Dans la forme de réalisation représentée, l'extrémité, ainsi susceptible d'être dégagée, de la pointe de touche 12, est propre à permettre un contact frontal, soit en bout, à sa propre extrémité 15, soit intermédiaire, à la faveur d'un épaulement globalement tronconique 16 légèrement en retrait par rapport à cette extrémité 15, et, présentant en outre, entre deux épaulements, dans cette forme de réalisation, en retrait, encore, par rapport à l'épaulement globalement tronconique 16 précédent, une cage élastiquement déformable radialement 17, elle est également propre à permettre un contact latéral.

Ces dispositions étant bien connues par elles-mêmes, elles ne seront pas décrites plus en détail ici.

A son autre extrémité, la pointe de touche 12 est en liaison électrique avec l'âme conductrice du cordon 10, et sur l'ensemble est surmoulé un manchon en matière isolante 19.

Le ressort 14 s'étend entre le fourreau de protection 13 et ce manchon 19, autour de la pointe de touche 12.

Dans la forme de réalisation représentée, le corps en matière isolante 11 est, par ailleurs, formé de deux coquilles 11A, 11B, l'une supérieure, l'autre inférieure, convenablement affrontées l'une à l'autre, et convenablement solidarisées l'une à l'autre, par exemple par soudage ou collage.

Du côté du cordon 10, ces coquilles 11A, 11B enserrent conjointement le manchon en matière isolante 19.

Du côté opposé, par contre, la coquille inférieure 11B forme, isolément, autour de la pointe de touche 12 et du fourreau de protection 13 entourant celle-ci, un nez tubulaire 20.

La coquille supérieure 11A ne forme donc en quelque sorte qu'un couvercle pour la coquille inférieure 11B.

Les dispositions correspondantes relevant de l'homme de l'art, et n'étant pas directement concernées par la présente invention, elles ne seront pas décrites plus en détail ici.

De manière connue en soi, le fourreau de protection 13, qui est monté coulissant dans le nez tubulaire 20 du corps en matière isolante 11, est verrouillable en position déployée de repos sous le contrôle d'un organe de déverrouillage 22 qui, à la disposition de l'usager, est propre à en permettre la libération.

Suivant l'invention, cet organe de déverrouillage 22 est également propre à permettre d'assurer le déplacement du fourreau de protection 13 de sa position déployée de repos à sa position rétractée de service.

Dans la forme de réalisation représentée, il se présente sous la forme d'un bouton poussoir, en saillie sur la surface supérieure de la coquille supérieure 11A du corps en matière isolante 11.

Plus précisément, dans cette forme de réalisation, cet organe de déverrouillage 22 présente, transversalement, disposées chacune respectivement de part et d'autre d'une crête 23, deux dépressions 24, 25, à profil largement arrondi, et à concavités orientées légèrement en oblique l'une par rapport à l'autre, la dépression la plus en avant, celle située du côté du nez 20, en l'espèce la dépression 24, étant en pratique celle destinée à permettre d'exercer une action sur cet organe de déverrouillage 22.

Dans la forme de réalisation représentée, l'organe de déverrouillage 22 est lié axialement au fourreau de protection 13.

En pratique, venu de moulage avec ce fourreau de protection 13, il est d'un seul tenant avec celui-ci.

Plus précisément, dans la forme de réalisation représentée, l'organe de déverrouillage 22 est relié au fourreau de protection 13 par une languette élastiquement déformable 27 formée à la faveur d'un crevé 28 de ce fourreau de protection 13.

Cette languette élastiquement déformable 27, qui s'étend longitudinalement en porte-à-faux en direction du cordon 10, parallèlement aux génératrices du fourreau de protection 13, présente, à distance de son raccordement à ce fourreau de protection 13, un cran 29 par lequel elle est propre à coopérer en verrouillage débrayable avec un cran 30 prévu à cet effet sur le corps en matière isolante 11.

Le cran 29 de la languette élastiquement déformable 27 s'étend transversalement, et il appartient, en pratique, à un épanouissement 32 que forme, à son extrémité libre, cette languette élastiquement déformable 27.

Cet épanouissement 32 s'étend tant transversalement, de part et d'autre de la partie courante de la languette élastiquement déformable 27, en sorte que, en plan, celle-ci a globalement une configuration en T, que radialement, en étant en saillie, en direction opposée à l'axe de l'ensemble, sur la surface extérieure de cette languette élastiquement déformable 27.

La surface supérieure de cet épanouissement 32 forme un pan incliné, orienté en direction opposée au cordon 10, et c'est celui de ses bords transversaux qui est le plus proche du cordon 10 qui forme le cran 29.

Corollairement, le cran 30 du corps en matière isolante 11 appartient à l'un des bords d'un évidement 33 prévu en creux à sa surface intérieure, cet évidement 33, qui est globalement de contour quadrangulaire, étant en pratique un évidement borgne affectant en creux la surface inférieure de sa coquille supérieure 11A.

Corollairement, l'organe de déverrouillage 22 se raccorde à la languette élastiquement déformable 27 par un pied 34, qui traverse le corps en matière isolante 11, et, plus précisément, sa coquille supérieure 11A, à la faveur d'une fente 35 prévue longitudinalement sur cette coquille supérieure 11A, parallèlement à l'axe de l'ensemble.

En pratique, ce pied 34 est établi au droit de l'épanouissement 32 de la languette élastiquement déformable 27, et s'il a, longitudinalement, même dimension que celui-ci, il est, transversalement, de dimension moindre.

Ce pied 34 interrompt, dans sa zone médiane, le cran 29 de la languette élastiquement déformable 27, et, de même, la fente 35 interrompt, dans sa zone médiane, le cran 30 du corps en matière isolante 11.

L'organe de déverrouillage 22 s'étend en porte-à-faux, en direction du cordon 10, à compter de ce pied 34.

De préférence, il est guidé latéralement, parallèlement à l'axe de l'ensemble.

Dans la forme de réalisation représentée, la coquille supérieure 11A du corps en matière isolante 11 présente, pour ce faire, en saillie sur sa surface extérieure, disposés chacun respectivement de part et d'autre de cet organe de déverrouillage 22, deux rebords 36 qui, en pratique, se rejoignent l'un l'autre en U du côté du cordon 10.

Pour la configuration déployée de repos du fourreau de protection 13, et du seul fait de l'élasticité de la languette élastiquement déformable 27, l'épanouissement 32 que forme cette languette élastiquement déformable 27 est normalement engagé, par sa partie supérieure, dans l'évidement 33, dont il est complémentaire, du corps en matière isolante 11.

Le cran 29 de cet épanouissement 32 étant ainsi en prise avec le cran 30 de cet évidement 33, figures 2, 3 et 4, le fourreau de protection 13 est alors verrouillé.

Il le demeure, même s'il lui est appliqué une poussée, pourvu, bien entendu, que cette poussée soit modérée, et, en pratique, inférieure à 1 décanewton.

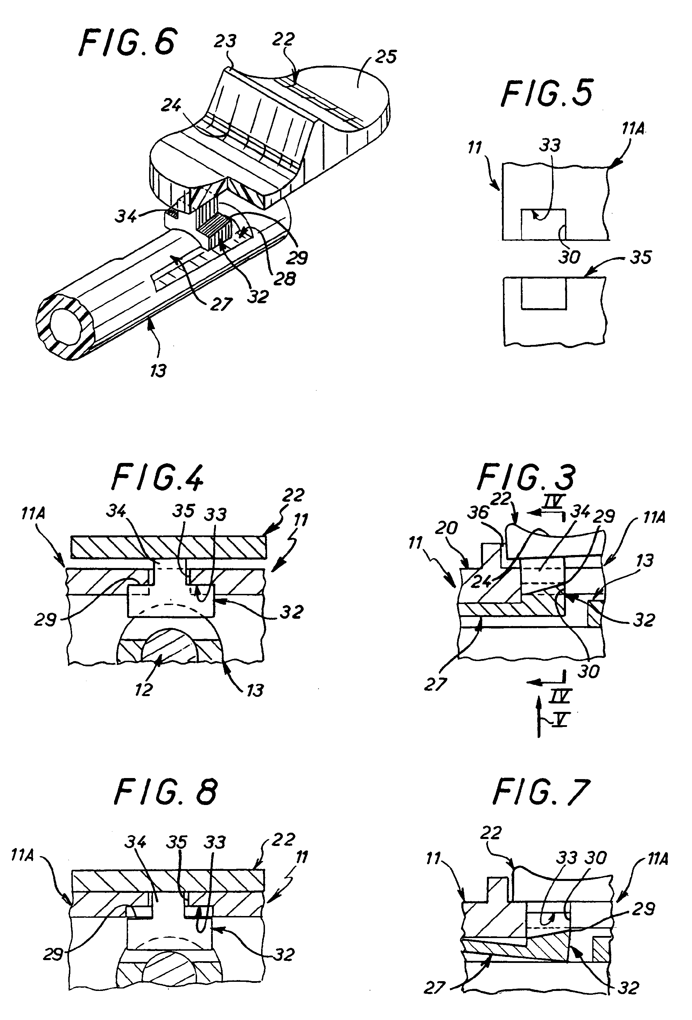

Si, par contre, et suivant la flèche F1 de la figure 2, il est exercé, du doigt, une action d'enfoncement sur l'organe de déverrouillage 22, en pratique à la faveur de la dépression avant 24 de celui-ci, cette action d'enfoncement suffit à provoquer, tel qu'illustré par les figures 7 et 8, le dégagement de l'épanouissement 32 de la languette élastiquement déformable 27 par rapport à l'évidement 33 du corps en matière isolante 11, et il est dès lors possible, d'un même mouvement, d'entraîner, axialement, suivant la flèche F2 de la figure 9, et à l'aide de ce même organe de déverrouillage 22, le fourreau de protection 13, jusqu'à ce que, ce fourreau de protection 13 atteignant sa position rétractée de service, tel que représenté sur la figure 9, l'extrémité de la pointe de touche 12 soit dégagée.

Lorsque l'action exercée sur l'organe de déverrouillage 22 est relâchée, le ressort 14 ramène l'ensemble à sa position initiale déployée de repos, avec un nouveau verrouillage du fourreau de protection 13 sur le corps en matière isolante 11.

De préférence, il est donné à ce corps en matière isolante 11 une largeur égale au double de l'entr'axe international pour les broches ou alvéoles des prises de courant usuelles, soit sensiblement 19 mm.

Deux testeurs suivant l'invention peuvent ainsi avantageusement être mis en oeuvre côte à côte pour un contact simultané sur deux de tels alvéoles ou deux de telles broches.

La présente invention ne se limite d'ailleurs pas à la forme de réalisation décrite et représentée, mais englobe toute variante d'exécution, qui restent cependant dans la portée des revendications.

**Revendications**

1. Testeur comportant, portée par un corps en matière isolante (11), une pointe de touche (12) propre à permettre l'établissement d'un contact, avec, entourant ladite pointe de touche (12), un fourreau de protection (13) qui, à l'encontre de moyens élastiques de rappel (14), est monté mobile entre une position déployée de repos, pour laquelle il s'étend au-delà de l'extrémité (15) de la pointe de touche (12), et une position rétractée, de service, pour laquelle il dégage au moins partiellement celle-ci, et qui est verrouillable en position déployée de repos sous le contrôle d'un organe de déverrouillage (22) propre à en permettre la libération, caractérisé en ce que ledit organe de déverrouillage (22) est également propre à permettre d'assurer le déplacement du fourreau de protection (13) de sa position déployée de repos à sa position rétractée de service.

2. Testeur suivant la revendication 1, caractérisé en ce que l'organe de déverrouillage (22) est lié axialement au fourreau de protection (13).

3. Testeur suivant la revendication 2, caractérisé en ce que l'organe de déverrouillage (22) est d'un seul tenant avec le fourreau de protection (13).

4. Testeur suivant l'une quelconque des revendications 2, 3, caractérisé en ce que l'organe de déverrouillage (22) est relié au fourreau de protection (13) par une languette élastiquement déformable (27), qui, à distance de son raccordement audit fourreau de protection (13), présente un cran (29) par lequel elle est propre à coopérer en verrouillage débrayable avec un cran (30) prévu à cet effet sur le corps en matière isolante (11).

5. Testeur suivant la revendication 4, caractérisé en ce que le cran (29) de la languette élastiquement déformable (27) appartient à un épanouissement (32) de son extrémité libre.

6. Testeur suivant l'une quelconque des revendications 4, 5, caractérisé en ce que le cran (30) du corps en matière isolante (11) appartient à l'un des bords d'un évidement (33) prévu en creux à sa surface intérieure.

7. Testeur suivant l'une quelconque des revendications 4 à 6, caractérisé en ce que la languette élastiquement déformable (27) est formée à la faveur d'un crevé (28) du fourreau de protection (13).

8. Testeur suivant l'une quelconque des revendications 4 à 8, caractérisé en ce que l'organe de déverrouillage (22) se raccorde à la languette élastiquement déformable (27) par un pied (34) qui traverse le corps en matière isolante (11) à la faveur d'une fente (35) de celui-ci.

9. Testeur suivant les revendications 5 et 8, prises conjointement, caractérisé en ce que le pied (34) de l'organe de déverrouillage (22) est établi au droit de l'épanouissement (32) de la languette élastiquement déformable (27) et est, transversalement, de dimension moindre que celui-ci.

10. Testeur suivant l'une quelconque des revendications 1 à 9, caractérisé en ce que l'organe de déverrouillage (22) est guidé latéralement, le corps en matière isolante (11) présentant, en saillie sur sa surface extérieure, disposés chacun respectivement de part et d'autre de cet organe de déverrouillage (22), deux rebords (36).

**Patentansprüche**

1. Tester mit einer von einem Körper (11) aus isolierendem Werkstoff getragenen Kontaktspitze (12), die geeignet ist, die Herstellung eines Kontakts zu gestatten, und einer diese Kontaktspitze (12) umgebenden Schutzhülse (13), die entgegen elastischen Rückholmitteln (14) beweglich zwischen einer ausgefahrenen Ruhestellung, in der sie sich über das Ende (15) der Kontaktspitze (12) hinaus erstreckt, und einer zurückgezogenen Betriebsstellung montiert ist, in der sie diese wenigstens teilweise freilegt, und die in ausgefahrener Ruhestellung unter der Steuerung eines Entriegelungsorgans (22) verriegelbar ist, das geeignet ist, ihre Freigabe zu gestatten, dadurch gekennzeichnet, daß dieses Entriegelungsorgan (22) ferner geeignet ist, die Bewegung der Schutzhülse (13) aus ihrer ausgefahrenen Ruhestellung in ihre zurückgezogene Betriebsstellung zu gestatten.

2. Tester nach Anspruch 1, dadurch gekennzeichnet, daß das Entriegelungsorgan (22) axial mit der Schutzhülse (13) verbunden ist.

3. Tester nach Anspruch 2, dadurch gekennzeichnet, daß das Entriegelungsorgan (22) mit der Schutzhülse (13) aus einem Stück besteht.

4. Tester nach einem der Ansprüche 2, 3, dadurch gekennzeichnet, daß das Entriegelungsorgan (22) mit der Schutzhülse (13) durch eine elastisch verformbare Zunge (27) verbunden ist, die in einem bestand von ihrem Anschluß an die Schutzhülse (13) eine Raste (29) besitzt, mit der sie in auskuppelbarer Verriegelung mit einer Raste (30) zusammenwirken kann, die zu diesem Zweck an dem Körper (11) aus isolierendem Werkstoff vorgesehen ist.

5. Tester nach Anspruch 4, dadurch gekennzeichnet, daß die Raste (29) der elastisch verformbaren Zunge (27) zu einer Verdickung (32) ihres freien Endes gehört.

6. Tester nach einem der Ansprüche 4, 5, dadurch gekennzeichnet, daß die Raste (30) des Körpers (11) aus isolierendem Werkstoff zu einem der Ränder einer an ihrer . inneren Oberfläche ausgehöhlten Ausnehmung (33) gehört.

7. Tester nach einem der Ansprüche 4 bis 6, dadurch gekennzeichnet, daß die elastisch verformbare Zunge (27) durch einen Ausschnitt (28) der Schutzhülse(13) geformt ist.

8. Tester nach einem der Ansprüche 4 bis 8, dadurch gekennzeichnet, daß das Entriegelungsorgan (22) an die elastisch verformbare Zunge (27) durch einen Fuß (34) angeschlossen ist, der den Körper (11) aus isolierendem Werkstoff über einen Schlitz (35) dieses Körpers durchquert.

9. Tester nach den Ansprüchen 5 und 8 zusammen, dadurch gekennzeichnet, daß der Fuß (34) des Entriegelungsorgans (22) über der Verdickung (32) der elastisch verformbaren Zunge (27) angeordnet ist und in Querrichtung von kleinerer Abmessung als diese ist.

10. Tester nach einem der Ansprüche 1 bis 9, dadurch gekennzeichnet, daß das Entriegelungsorgan (22) seitlich geführt ist, wobei der Körper (11) aus isolierendem Werkstoff zwei Randleisten (36) besitzt, die an seiner äußeren Oberfläche hervorstehen und jeweils zu beiden Seiten dieses Entriegelungsorgans (22) angeordnet sind.

## Claims

1. A tester comprising, carried by a body (11) of insulating material, a contact point (12) capable of permitting the establishment of a contact, with, surrounding said contact point (12), a protective sheath (13) which is mounted movably against resilient return means (14) between an extended rest position in which it extends beyond the end (15) of the contact point (12) and a retracted operative position in which it at least partially exposes the contact point, and which is lockable in the extended rest position under the control of an unlocking member (22) capable of permitting it to be freed, characterised in that said unlocking member (22) is also capable of making it possible to provide for displacement of the protective sheath (13) from its extended rest position to its retracted operative position.

2. A tester according to claim 1 characterised in that the unlocking member (22) is axially connected to the protective sheath (13).

3. A tester according to claim 2 characterised in that the unlocking member (22) is in one piece with the protective sheath (13).

4. A tester according to either one of claims 2 and 3 characterised in that the unlocking member (22) is connected to the protective sheath (13) by a resiliently deformable tongue portion (27) which, at a spacing from its connection to said protective sheath (13), has a latch portion (29) by way of which it is capable of co-operating in a condition of releasable locking with a latch portion (30) provided for that purpose on the body (11) of insulating material.

5. A tester according to claim 4 characterised in that the latch portion (29) of the resiliently deformable tongue portion (27) belongs to an enlargement (32) of its free end.

6. A tester according to either one of claims 4 and 5 characterised in that the latch portion (30) of the body (11) of insulating material belongs to one of the edges of a recess (33) provided in hollow relationship at its internal surface.

7. A tester according to any one of claims 4 to 6 characterised in that the resiliently deformable tongue portion (27) is formed by means of a cut (28) in the protective sheath (13) .

8. A tester according to any one of claims 4 to 8 characterised in that the unlocking member (22) is connected to the resiliently deformable tongue portion (27) by a leg (34) which passes through the body (11) of insulating material by way of a slot (35) therein.

9. A tester according to claims 5 and 8 in combination characterised in that the leg (34) of the unlocking member (22) is disposed in line with the enlargement (32) of the resiliently deformable tongue portion (27) and transversely is of a smaller dimension than same.

10. A tester according to any one of claims 1 to 9 characterised in that the unlocking member (22) is guided laterally, the body (11) of insulating material having two rim portions (36) in projecting relationship on its external surface each disposed on respective sides of said unlocking member (22).

FIG. 1

FIG.2

FIG.9

FIG.6

FIG.5

FIG.4

FIG.3

FIG.8

FIG.7